# EUROPEAN PATENT APPLICATION

(11) **EP 4 411 805 A1**
(43) Date of publication of application: **07.08.2024**
(21) Application number: 21962869.0
(22) Date of filing: 04.11.2021
(51) Int. Cl.: H01L 23/28

(54) **PACKAGE STRUCTURE OF OPTICAL COMMUNICATION MODULE AND PREPARATION METHOD**

(71) Applicant: Huawei Technologies Co., Ltd., Shenzhen, Guangdong 518129 (CN)
(72) Inventor: ZHANG, Wenqi, Shenzhen, Guangdong 518129 (CN)
(74) Representative: Maiwald GmbH
(86) International application number: PCT/CN2021/128655
(87) International publication number: WO 2023/077352

(57) **Abstract**

Embodiments of this application provide a packaging structure of an optical communication module and a production method thereof. The packaging structure includes: a first redistribution structure, where a distribution layer is disposed in the first redistribution structure; a plastic packaging structure, where the plastic packaging structure wraps a surface other than an upper surface of the first redistribution structure, the plastic packaging structure on a periphery of the first redistribution structure is provided with at least one via hole, and each of the at least one via hole penetrates an upper surface and a lower surface of the plastic packaging structure; and a first chip and a second chip, where the first chip and the second chip are disposed on the first redistribution structure and the plastic packaging structure, the first chip is connected to the second chip by using the distribution layer, and at least a part of lead-out ends of the first chip and at least a part of lead-out ends of the second chip are led from the upper surface of the plastic packaging structure to the lower surface by using the at least one via hole, so that wafer-level packaging of the first chip and the second chip can be implemented. In this way, in a case in which a short length of interconnection between packaged chips is satisfied, packaging costs can be reduced.

## Description

### TECHNICAL FIELD

Embodiments of this application relate to the field of semiconductor packaging technologies, and in particular, to a packaging structure of an optical communication module and a production method thereof.

### BACKGROUND

With development of technologies such as communication, artificial intelligence, and the like, there has been an increasing demand for a large amount of data flow and transfer. A hardware module that supports such as optical communication needs to have functions such as low power consumption, a high transmission rate, a low delay, a plurality of bandwidths, system integration, and the like. To satisfy a function requirement of an optical communication module, a length of interconnection between an electronic chip (for example, a driver chip and a trans-impedance amplifier chip) and a photonic chip (for example, a modem chip and a photodetector chip) integrated into the optical communication module is minimized. Because density of lead interconnection between the photonic chip and the electronic chip is high, and the photonic chip needs to reserve a port configured to couple a fiber array unit and a waveguide array unit, a conventional lead bonding packaging process cannot satisfy a requirement for a short length of the lead interconnection between the chips.

It is proposed in the industry that a through-silicon via (TSV, through silicon via) is disposed on the photonic chip and the electronic chip, and the photonic chip and the electronic chip are vertically interconnected and then connected to a substrate by using the TSV, to reduce a length of interconnection between the chips. However, disposing the TSV on an active chip requires a complex process. In addition, disposing the TSV on the chip generally causes a chip stress problem, and a stress safety region needs to be disposed on the chip. This reduces an effective utilization area of the chip, and increases chip packaging costs of the optical communication module. Therefore, in a case in which a short length of lead interconnection between the chips in the optical communication module is satisfied, a problem about how to reduce chip packaging costs and complexity of the optical communication module needs to be resolved.

### SUMMARY

According to a packaging structure of an optical communication module and a production method thereof provided in this application, in a case in which a short length of interconnection between packaged chips is satisfied, packaging costs can be reduced.

To achieve the foregoing objective, the following technical solutions are applied in this application.

According to a first aspect, an embodiment of this application provides a packaging structure of an optical communication module. The packaging structure of the optical communication module includes: a first redistribution structure, where a distribution layer is disposed in the first redistribution structure; a plastic packaging structure, where the plastic packaging structure wraps a surface other than an upper surface of the first redistribution structure, the plastic packaging structure on a periphery of the first redistribution structure is provided with at least one via hole, and each of the at least one via hole penetrates an upper surface and a lower surface of the plastic packaging structure; and a first chip and a second chip, where the first chip and the second chip are disposed on the first redistribution structure and the plastic packaging structure, the first chip is connected to the second chip by using the distribution layer, and a part of lead-out ends of the first chip and a part of lead-out ends of the second chip are led from the upper surface of the plastic packaging structure to the lower surface by using the at least one via hole, to communicate with a conductive line on a printed circuit board.

The first chip in embodiments of this application may be a photonic chip, to implement optical signal receiving and sending and optical-to-electrical signal conversion. For example, the chip includes but is not limited to one or more of a coupler (for example, a side coupler or a grating coupler) configured to couple a fiber array unit, a photodetector, or a modem. The devices may be integrated into one or more dies or packaging bodies to form one or more photonic chips. The second chip may be either a photonic chip or an electronic chip. When the second chip is an electronic chip, the electronic chip may implement amplification and processing of an electrical signal, and for example, may include but is not limited to: a driver chip or a trans-impedance amplifier chip.

According to the packaging structure of the optical communication module provided in embodiments of this application, the first redistribution structure is disposed, and the photonic chip is connected to the electronic chip by using the distribution layer in the first redistribution structure, so that a length of a conductive line connected between the chips can be shorter. In addition, vias are provided on the plastic packaging structure on two sides of the first redistribution structure, and a via configured to be connected to the printed circuit board may not need to be provided inside the photonic chip or the electronic chip. The photonic chip and the electronic chip are led from the upper surface of the first redistribution structure to a lower surface by using the vias in the plastic packaging structure, and are connected to the printed circuit board disposed on the lower surface of the first redistribution structure. This can simplify a production process of the packaging structure of the optical communication module, reduce complexity of producing the packaging structure of the optical communication module, and further reduce costs of producing the packaging structure of the optical communication module.

Further, a port configured to couple the fiber array unit is generally disposed on the first chip in embodiments of this application. In addition, through production of the distribution layer in a silicon crystal, the first redistribution structure provided in embodiments of this application may be formed. When the first chip and the second chip are packaged by using a redistribution structure with a via hole, if a conventional wafer-level packaging process is applied, a plastic packaging material formed in the process blocks the port on the photonic chip, that is, it is difficult to implement wafer-level packaging by using the conventional redistribution structure with the via hole, and the redistribution structure needs to be cut into a single wafer for independent packaging of the chip. However, because the redistribution structure is excessively thin (for example, a standard thickness is 100 micrometers) and has an excessively large size, manufacturing costs of the redistribution structure are high, and a yield rate in a process of independently packaging a chip is low. Therefore, when the first chip and the second chip are packaged by using the redistribution structure with the via hole, packaging costs of the optical communication module are greatly increased. In embodiments of this application, the plastic packaging structure is formed on the periphery of the first redistribution structure, and the via hole is formed on the plastic packaging structure, so that the first redistribution structure may be produced by using the conventional wafer-level packaging process, that is, a reconstructed wafer is formed after the periphery of the first redistribution structure is wrapped by the plastic packaging structure. This can avoid separately cutting the redistribution structure and improve a yield rate of chip packaging. In addition, the plastic packaging structure is provided with the via hole, so that a size of the first redistribution structure is not excessively large. This reduces chip packaging costs.

Based on the first aspect, in a possible implementation, the plastic packaging structure includes a plurality of via holes; the first chip is disposed on the upper surfaces of the first redistribution structure and the plastic packaging structure by using a plurality of first micro bumps, the first chip is connected to a conductive line in the distribution layer by using a second micro bump in the plurality of first micro bumps, and the first chip is connected to a first via hole in the plurality of via holes by using a third micro bump in the plurality of first micro bumps; and the second chip is disposed on the upper surfaces of the first redistribution structure and the plastic packaging structure by using a plurality of fourth micro bumps, the second chip is connected to the conductive line in the distribution layer by using a fifth micro bump in the plurality of fourth micro bumps, and the second chip is connected to a second via hole in the plurality of via holes by using a sixth micro bump in the plurality of fourth micro bumps.

In this embodiment of this application, one part of lead-out ends of the first chip are connected to the conductive line in the distribution layer by using the second micro bump, and one part of lead-out ends of the second chip are connected to the conductive line in the distribution layer by using the fifth micro bump, so that the first chip communicates with the second chip. The other part of lead-out ends of the first chip are connected to the first via hole in the plastic packaging structure by using the third micro bump, so that the part of lead-out ends of the first chip may be led from the upper surface of the plastic packaging structure to the lower surface, to communicate with the conductive line (for example, a common power supply cable, a common ground cable, or the like) on the printed circuit board. Similarly, the other part of lead-out ends of the second chip communicate with the second via hole in the plastic packaging structure by using the sixth micro bump, so that the part of lead-out ends of the second chip may be led from the upper surface of the plastic packaging structure to the lower surface, to communicate with the conductive line (for example, a common power supply cable, a common ground cable, or the like) on the printed circuit board.

Based on the first aspect, in a possible implementation, a second redistribution structure is further disposed on the upper surface of the first redistribution structure and the upper surface of the plastic packaging structure; and the first chip is connected to the second chip by using the first redistribution structure and the second redistribution structure.

In some scenarios, if another chip is further disposed between the first chip and the second chip, the first chip may not communicate with the second chip by using only the first redistribution structure. The second redistribution structure is disposed, so that more chips can be packaged in the packaging structure of the optical communication module provided in embodiments of this application, to implement communication between the more chips.

Based on the first aspect, in a possible implementation, the first chip includes a port configured to couple a fiber array unit; and the port is disposed on a first surface or a second surface of the first chip, the first surface is a surface that is of the first chip and that is close to the plastic packaging structure, and the second surface is a surface that is of the first chip and that is away from the plastic packaging structure.

Based on the first aspect, in a possible implementation, when the port configured to couple the fiber array unit is disposed on the first surface of the first chip, an insulation material is filled between a region that is of the first chip and that is other than a region in which the port is disposed, and the first redistribution structure and the plastic packaging structure; and an insulation material is filled between the second chip and both of the first redistribution structure and the plastic packaging structure. The packaging structure can implement chip-scale packaging of the optical communication module. The insulation material is disposed, so that support and protection between the chip and the plastic packaging structure and between the chip and the first redistribution structure can be provided, to prevent the first redistribution structure or the chip from breaking under a stress, and improve reliability of the packaging structure.

Based on the first aspect, in a possible implementation, when the port configured to couple the fiber array unit is disposed on the second surface of the first chip, surfaces that are of the first chip and the second chip and that are other than a surface away from the first redistribution structure are wrapped by a plastic packaging material. The packaging structure can implement wafer-level packaging of the optical communication module. The plastic packaging material is disposed, so that support and protection can be provided for the first chip and the second chip.

Based on the first aspect, the first redistribution structure provided in embodiments of this application includes at least one layer of a patterned conductive line and an insulation material for isolating the patterned conductive line. In addition, the first redistribution structure is further provided with a via, the via is filled with or electroplated with a conductive material, and the first chip communicates with the second chip by using the conductive line on the first redistribution structure and the via provided on the first redistribution structure.

Based on the first aspect, the second redistribution structure provided in embodiments of this application includes at least one layer of a patterned conductive line and an insulation material for isolating the patterned conductive line. In addition, the second redistribution structure is further provided with a via, the via is filled with or electroplated with a conductive material, and the first chip communicates with the second chip by using the conductive line on the second redistribution structure, the via on the second redistribution structure, the via hole, and the first redistribution structure.

According to a second aspect, an embodiment of this application provides an optical communication device. The optical communication device includes a printed circuit board and the packaging structure of the optical communication module according to the first aspect; at least one bump is disposed on a lower surface of the plastic packaging structure, and the at least a part of lead-out ends of the first chip and the at least a part of lead-out ends of the second chip are correspondingly connected to the at least one via hole by using the at least one bump; the conductive line is disposed on the printed circuit board; and the at least one bump is welded to the printed circuit board, and the first chip and the second chip are connected to the conductive line on the printed circuit board by using the at least one via hole and the at least one bump.

According to a third aspect, an embodiment of this application provides a production method of a packaging structure of an optical communication module. The production method includes: producing a distribution layer in a silicon crystal, to form a first redistribution structure; forming a plastic packaging structure on a periphery of the first redistribution structure, where the plastic packaging structure wraps a surface other than an upper surface of the first redistribution structure; forming at least one via hole in the plastic packaging structure on the periphery of the first redistribution structure, where each of the at least one via hole penetrates an upper surface and a lower surface of the plastic packaging structure; and disposing a first chip and a second chip on the first redistribution structure and the plastic packaging structure, where the first chip is connected to the second chip by using the distribution layer, and a part of lead-out ends of the first chip and a part of lead-out ends of the second chip are led from the upper surface of the plastic packaging structure to the lower surface by using the at least one via hole, to communicate with a conductive line on a printed circuit board.

Based on the third aspect, in a possible implementation, the disposing a first chip and a second chip on the first redistribution structure and the plastic packaging structure includes: disposing the first chip on the upper surfaces of the first redistribution structure and the plastic packaging structure by using a plurality of first micro bumps, where the first chip is connected to a conductive line in the distribution layer by using a second micro bump in the plurality of first micro bumps, and the first chip is connected to a first via hole in the plurality of via holes by using a third micro bump in the plurality of first micro bumps; and disposing the second chip on the upper surfaces of the first redistribution structure and the plastic packaging structure by using a plurality of fourth micro bumps, where the second chip is connected to the conductive line in the distribution layer by using a fifth micro bump in the plurality of fourth micro bumps, and the second chip is connected to a second via hole in the plurality of via holes by using a sixth micro bump in the plurality of fourth micro bumps.

Based on the third aspect, in a possible implementation, the disposing a first chip and a second chip on the first redistribution structure and the plastic packaging structure includes: forming a second redistribution structure on the upper surfaces of the first redistribution structure and the plastic packaging structure; and disposing the first chip and the second chip on the second redistribution structure, where the first chip is connected to the second chip by using the first redistribution structure and the second redistribution structure.

Based on the third aspect, in a possible implementation, the first chip includes a port configured to couple a fiber array unit, and when the port is disposed on a first surface that is of the first chip and that is close to the plastic packaging structure, the production method further includes: filling an insulation material at bottoms of the first chip and the second chip, and on the first redistribution structure and the plastic packaging structure, where the insulation material does not cover a region in which the port is located.

Based on the third aspect, in a possible implementation, the first chip includes a port configured to couple a fiber array unit, and when the port is disposed on a second surface that is of the first chip and that is away from the plastic packaging structure, the production method further includes: forming a plastic packaging material around the first chip and the second chip, where the plastic packaging material wraps surfaces that are of the first chip and the second chip and that are other than a surface away from the first redistribution structure; and etching a back surface of the first chip to expose the port.

It should be understood that the technical solutions in the second aspect and the third aspect of this application are consistent with the technical solution in the first aspect of this application. Beneficial effects achieved in the various aspects and corresponding feasible implementations are similar, and details are not described again.

### BRIEF DESCRIPTION OF DRAWINGS

To describe technical solutions in embodiments of this application more clearly, the following briefly describes the accompanying drawings for describing embodiments of this application. It is clear that the accompanying drawings in the following descriptions show merely some embodiments of this application, and a person of ordinary skill in the art may still derive other drawings from these accompanying drawings without creative efforts.
FIG. 1 is a schematic diagram of a structure of a packaging structure of an optical communication module according to an embodiment of this application;
FIG. 2 is a schematic diagram of still another structure of a packaging structure of an optical communication module according to an embodiment of this application;
FIG. 3 is a schematic diagram of still another structure of a packaging structure of an optical communication module according to an embodiment of this application;
FIG. 4 is a schematic diagram of still another structure of a packaging structure of an optical communication module according to an embodiment of this application;
FIG. 5 is a schematic diagram of still another structure of a packaging structure of an optical communication module according to an embodiment of this application;
FIG. 6 is a flowchart of a production method of the packaging structure of the optical communication module shown in FIG. 1 according to an embodiment of this application; and
FIG. 7A to FIG. 7D are schematic diagrams of structures in a process of producing the packaging structure of the optical communication module shown in FIG. 1.

### DESCRIPTION OF EMBODIMENTS

With reference to accompanying drawings in embodiments of this application, the following clearly and completely describes the technical solutions in embodiments of this application. It is clear that the described embodiments are a part but not all of embodiments of this application. All other embodiments obtained by a person of ordinary skill in the art based on embodiments of this application without creative efforts shall fall within the protection scope of this application.

"First", "second", and the like mentioned in this specification do not indicate any order, quantity, or importance, but are merely used for distinguishing between different components. Likewise, a term such as "a/an", "one", or the like does not indicate a quantity limitation, but means at least one.

In embodiments of this application, the term "example", "for example", or the like is used to represent giving an example, an illustration, or a description. Any embodiment or design solution described as an "example" or "for example" in embodiments of this application should not be explained as being more preferred or having more advantages than another embodiment or design solution. To be precise, the terms such as "example", "for example", or the like is intended to present a related concept in a specific manner. In the descriptions of embodiments of this application, unless otherwise stated, "a plurality of " means two or more than two. For example, a plurality of chips means two or more than two chips.

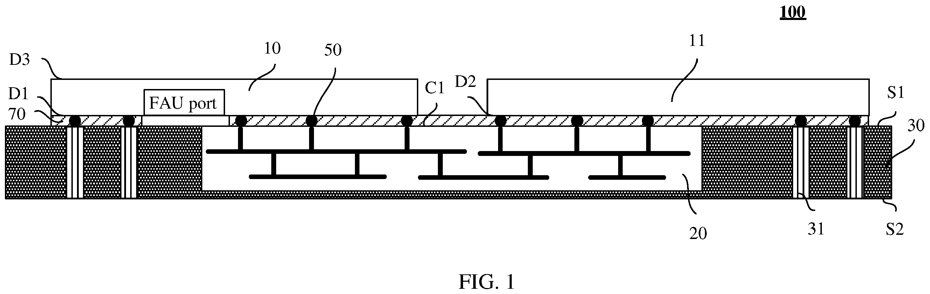

Based on a packaging structure of an optical communication module provided in embodiments of this application, a plurality of chips can be packaged in a same packaging body. The plurality of chips can be horizontally spaced, and each chip is connected to a remaining chip, a common power supply, and a common ground by using a redistribution structure, to implement signal exchange between the plurality of chips. The chip described in embodiments of this application may be a die (Die), a chip formed after a die and another chip or component (an active device, a passive device, or the like) are simply packaged, or a chip packaging structure formed after packaging, and this is not limited herein. The plurality of chips packaged in the packaging structure of the optical communication module may further include a photonic integrated circuit (Photonics Integrated Circuit, PIC) chip (hereinafter referred to as a photonic chip). The photonic chip implements optical signal receiving and sending and optical-to-electrical signal conversion. A device integrated into the photonic chip may include, for example, but is not limited to, a coupler (for example, a side coupler or a grating coupler) configured to couple a fiber array unit (fiber array unit, FAU), a photodetector (photo detector, PD), and a modem. The devices may be integrated into one or more dies or packaging bodies to form one or more photonic chips. In addition, in addition to the photonic chip, the plurality of chips packaged in the packaging structure of the optical communication module may further include an electronic integrated circuit (Electronic Integrated Circuit, EIC) chip (hereinafter referred to as an electronic chip). The electronic chip implements amplification and processing of an electrical signal, and the electronic chip, for example, may include but is not limited to: a driver chip and a trans-impedance amplifier (trans-impedance amplifier, TIA) chip. Further, in the packaging structure of the optical communication module provided in embodiments of this application, another chip may be further packaged, and the chips fit each other to implement an optical communication function. In addition, the packaging structure of the optical communication module in embodiments of this application may be implemented by using chip-scale packaging, or may be implemented by using a plurality of independent optical communication modules cut after packaging is performed through wafer reconstruction. The following describes, by using specific examples and with reference to the schematic diagrams of structures shown in FIG. 1 to FIG. 5, the packaging structure of the optical communication module provided in embodiments of this application.

Refer to FIG. 1. FIG. 1 is a schematic diagram of a structure of a packaging structure of an optical communication module according to an embodiment of this application. In FIG. 1, a packaging structure 100 of the optical communication module includes a coupler chip 10, a trans-impedance amplifier chip 11, a redistribution structure 20, and a plastic packaging structure 30. An upper surface C1 of the redistribution structure 20 is exposed, to be configured to be connected to the coupler chip 10 and the trans-impedance amplifier chip 11, and a remaining surface of the redistribution structure 20 is wrapped by the plastic packaging structure 30. An upper surface S1 of the plastic packaging structure 30 is flush with the upper surface C1 of the redistribution structure 20, to be configured to dispose a chip. A lower surface S2 side of the plastic packaging structure is configured to dispose a printed circuit board (printed circuit board, PCB). The coupler chip 10 and the trans-impedance amplifier chip 11 may be disposed on the upper surface C1 of the redistribution structure 20 and the upper surface S1 of the plastic packaging structure 30 by using one of a micro bump (micro-bump) and a copper pillar bump (Cu pillar). FIG. 1 schematically shows that the coupler chip 10 and the trans-impedance amplifier chip 11 may be disposed on the upper surface C1 of the redistribution structure 20 and the upper surface S1 of the plastic packaging structure 30 by using a micro bump 50.

The redistribution structure 20 includes at least one distribution layer, and each distribution layer includes a patterned conductive line and an insulation material for isolating the patterned conductive line. A conductive material configured to form the patterned conductive line may be metal, for example, one or a combination of metal such as copper (Cu), silver (Ag), aluminum (Al), and the like. The conductive material configured to form the patterned conductive line may alternatively be indium tin oxide (ITO), graphite, graphene, or the like. The insulation material may be an inorganic insulation material, an organic insulation material, or the like. When the redistribution structure 20 includes a plurality of distribution layers, the redistribution structure 20 may be further provided with a via (Via), and the via may include but is not limited to: a via hole, a buried hole, or the like. The via may be filled with or electroplated with a conductive material, and the distribution layers communicate with each other by using the via. FIG. 1 schematically shows that the redistribution structure 20 includes two distribution layers. The coupler chip 10 communicates with the trans-impedance amplifier chip 11 by using the distribution layer in the redistribution structure 20. It should be noted that the packaging structure 100 of the optical communication module may include one or more redistribution structures 20, and a quantity of the redistribution structures 20 may be determined based on a quantity of chips, density of a lead-out end of the chip, and a location of the lead-out end on the chip. The quantity of the redistribution structure 20 is not limited in embodiments of this application, and is set based on a requirement of an application scenario.

A material forming the plastic packaging structure 30 may include, for example, one or a combination of epoxy resin (epoxy molding compound, EMC), polyethylene, polypropylene, polyolefin, polyamide, and polyurethane. The material is disposed in the plastic packaging structure 30 around the redistribution layer 20, and the plastic packaging structure 30 is provided with a via hole 31 that penetrates the upper surface S1 and the lower surface S2 of the plastic packaging structure 30. The via hole 31 may be filled with or electroplated with a conductive material, and a part of lead-out ends (such as a power supply terminal and a ground terminal) of the coupler chip 10 and the trans-impedance amplifier chip 11 are led from the upper surface S1 of the plastic packaging structure 30 to the lower surface S2 by using the via hole 31, to be connected to the PCB disposed on a lower surface side of the plastic packaging structure 30. There may be a plurality of via holes 31, and each via hole 31 corresponds to one lead-out end on the chip. The packaging structure 100 shown in FIG. 1 is used as an example. It is assumed that two lead-out ends separately of the coupler chip 10 and the trans-impedance amplifier chip 11 need to be connected to the PCB. A side that is of the plastic packaging structure 30 and that is configured to dispose the coupler chip 10 may be provided with two via holes 31, and a side that is of the plastic packaging structure 30 and that is configured to dispose the trans-impedance amplifier chip 11 may also be provided with two via holes 31, that is, two via holes 31 are respectively disposed on the plastic packaging structure 30 on two sides of the redistribution structure 20 shown in FIG. 1.

A plurality of lead-out ends are formed on a surface D1 of the coupler chip 10, and a micro bump 50 is disposed on each lead-out end. In the plurality of lead-out ends of the coupler chip 10, one part of lead-out ends are disposed on the surface C1 of the redistribution structure 20 by using the micro bump 50, and communicate with the conductive line in each distribution layer in the redistribution structure 20; and the other part of lead-out ends are disposed on the surface S1 of the plastic packaging structure 30 by using the micro bump 50, and communicate with the conductive material in the via hole 31. A plurality of lead-out ends are also formed on a surface D2 of the trans-impedance amplifier chip 11, and a micro bump 50 is disposed on each lead-out end. In the plurality of lead-out ends of the trans-impedance amplifier chip 11, one part of lead-out ends are disposed on the surface C1 of the redistribution structure 20 by using the micro bump 50, and communicate with the conductive line in each distribution layer in the redistribution structure 20; and the other part of lead-out ends are disposed on the surface S1 of the plastic packaging structure 30 by using the micro bump 50, and communicate with the conductive material in the via hole 31. In this way, one part of lead-out ends of the coupler chip 10 are interconnected with one part of lead-out ends of the trans-impedance amplifier chip 11 by using the micro bump 50, the conductive line in the redistribution structure 20, and the micro bump 50; the other part of lead-out ends of the coupler chip 10 are led from the surface S1 of the plastic packaging structure 30 to the surface S2 of the plastic packaging structure 30 by using the micro bump 50 and the via hole 31, and are connected to a conductive line on the PCB; and the other part of lead-out ends of the trans-impedance amplifier chip 11 are led from the surface S1 of the plastic packaging structure 30 to the surface S2 of the plastic packaging structure 30 by using the micro bump 50 and the via hole 31, and are connected to the conductive line on the PCB. Further, to provide support and protection for the coupler chip 10, the trans-impedance amplifier chip 11, and the surface C1 of the redistribution structure 20, in the packaging structure 100 of the optical communication module shown in FIG. 1, an insulation material 70 is disposed between the coupler chip 10 and the redistribution structure 20 and between the trans-impedance amplifier chip 11 and the redistribution structure 20, and the insulation material may be, for example, an underfill (underfill). It should be noted that the insulation material 70 does not cover a port (that is an FAU port in FIG. 1) that is configured to couple an FAU and that is in the coupler chip 10, that is, the port configured to couple the FAU is exposed, to couple the FAU.

It can be learned from the packaging structure 100 of the optical communication module shown in FIG. 1 that the redistribution structure 20 is disposed, and the coupler chip 10 is connected to the trans-impedance amplifier chip 11 by using the distribution layer in the redistribution structure 20, so that a length of the conductive line connected between the chips can be shorter. In addition, the via hole 31 is provided on the plastic packaging structure 30, and a via configured to be connected to the PCB may not need to be disposed inside the coupler chip 10 or the trans-impedance amplifier chip 11. The coupler chip 10 and the trans-impedance amplifier chip 11 are led from the upper surface of the plastic packaging structure 30 to the lower surface by using the via hole 31 in the plastic packaging structure 30, and are connected to the PCB disposed on a lower surface side of the plastic packaging structure 30. This can simplify a production process of the packaging structure of the optical communication module, reduce complexity of producing the packaging structure, and further reduce costs of producing the packaging structure of the optical communication module.

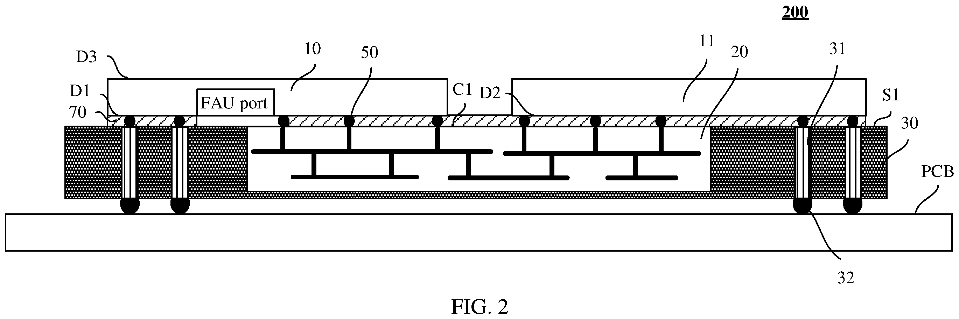

Based on the packaging structure 100 of the optical communication module shown in FIG. 1, further, a structure of an optical communication device is shown in FIG. 2. In addition to the packaging structure 100 of the optical communication module shown in FIG. 1, the optical communication device 200 shown in FIG. 2 further includes the PCB. In FIG. 2, a plurality of conductive bumps 32 are further disposed on the lower surface S2 of the plastic packaging structure 30. The plurality of conductive bumps 32 may be conductive balls, conductive columns, or the like. FIG. 2 schematically shows a case in which the conductive bump 32 is a conductive ball. One conductive bump 32 can correspond to one or more via holes 31. The plurality of conductive bumps 32 communicate with the plurality of via holes 31. The packaging structure 100 of the optical communication module shown in FIG. 1 is welded to the PCB by using the plurality of conductive bumps 32. In addition, when the plurality of conductive bumps 32 are welded to the PCB, the plurality of conductive bumps 32 communicate with the conductive line on the PCB. Therefore, the coupler chip 10 and the trans-impedance amplifier chip 11 communicate with the conductive line on the PCB by using the via hole 31 and the conductive bump 32.

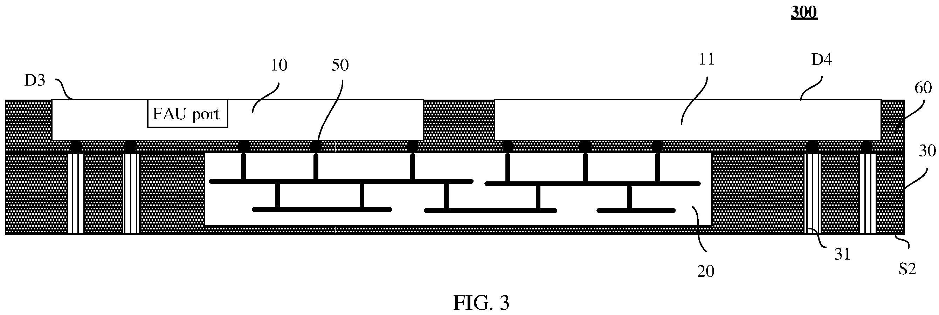

In embodiments of this application, the port that is configured to couple the FAU and that is in the coupler chip 10 may be disposed on the surface D1 of the coupler chip 10, or may be disposed on the surface D3 that is of the coupler chip 10 and that is opposite to the surface D1. When the port that is configured to couple the FAU and that is in the coupler chip 10 is disposed on the surface D1 (that is, a side close to the plastic packaging structure 30) of the coupler chip 10, the coupler chip 10 may be a side coupler chip or a grating coupler chip. When the port that is configured to couple the FAU and that is in the coupler chip 10 is disposed on the surface D3 (that is, a side away from the plastic packaging structure 30) of the coupler chip 10, the coupler chip 10 is a grating coupler chip. In the packaging structure 100 of the optical communication module shown in FIG. 1, a case in which the port (the FAU port in FIG. 1) that is configured to couple the FAU and that is in the coupler chip 10 is disposed on the surface D1 of the coupler chip 10 is schematically shown. Still refer to FIG. 3. In a packaging structure 300 of the optical communication module shown in FIG. 3, a case in which the port (an FAU port in FIG. 3) that is configured to couple the FAU and that is in the coupler chip 10 is disposed on the surface D3 of the coupler chip 10. Different from the packaging structure 100 of the optical communication module shown in FIG. 1, in the packaging structure 300 of the optical communication module shown in FIG. 3, all surfaces that are of the coupler chip 10 and that are except the surface D3 away from the plastic packaging structure 30 are wrapped by a plastic packaging material 60. Similarly, all surfaces that are of a variable gain amplifier chip 11 and that are except a surface away from the plastic packaging structure 30 are wrapped by the plastic packaging material 60. In this way, the port that is configured to couple the FAU and that is in the coupler chip 10 can be exposed, and better protection and support can be provided for each chip. A specific material of the plastic packaging material 60 may be the same as the material forming the plastic packaging structure 30, and details are not described again. In addition, structures included in the packaging structure 300 of the optical communication module shown in FIG. 3, and a relative location relationship and an interconnection relationship between the structures are the same as structures included in the packaging structure 100 of the optical communication module shown in FIG. 1, and a relative location relationship and an interconnection relationship between the structures. For details, refer to related descriptions of the packaging structure 100 of the optical communication module, and details are not described again.

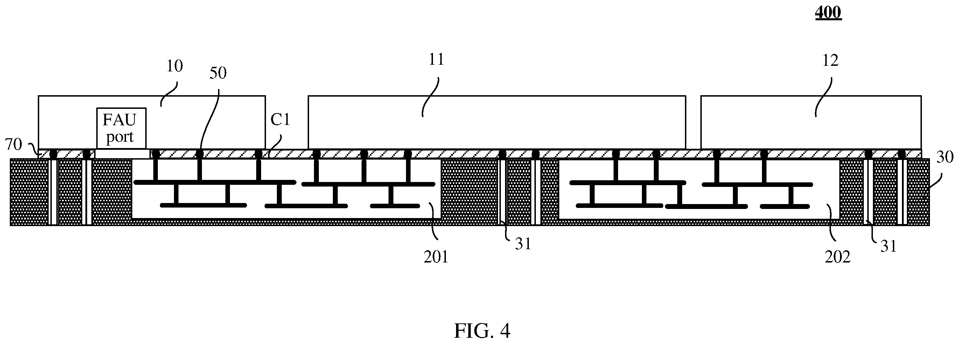

In the packaging structures of the optical communication module shown in FIG. 1 to FIG. 3, the chips packaged in the packaging structure of the optical communication module include the coupler chip 10 and the variable gain amplifier chip 11, and the two chips are used as examples for description. In another possible implementation, another chip (for example, the coupler chip 10 and a driver chip) may be packaged in the packaging structure of the optical communication module. In addition, more chips (for example, the coupler chip 10, the variable gain amplifier chip 11, the driver chip, and a processor chip) may be packaged in the packaging structure of the optical communication module. When more chips are packaged in the packaging structure of the optical communication module, the packaging structure of the optical communication module may include more redistribution structures 20. As shown in FIG. 4, FIG. 4 schematically shows that the coupler chip 10, the variable gain amplifier chip 11, and a driver chip 12 are packaged in a packaging structure 400 of the optical communication module. FIG. 4 schematically shows two redistribution structures: a redistribution structure 201 and a redistribution structure 202. Structures of the redistribution structure 201 and the redistribution structure 202 are the same as a structure of the redistribution structure 20 shown in FIG. 1, and details are not described again. The coupler chip 10 is connected to the variable gain amplifier chip 11 by using a conductive line in the redistribution structure 201, and the variable gain amplifier chip 11 is connected to the driver chip 12 by using a conductive line in the redistribution structure 202. In addition, similar to the packaging structure 100 of the communication module shown in FIG. 1, surfaces other than upper surfaces of the redistribution structure 201 and the redistribution structure 202 are covered by the plastic packaging structure 30. A part of lead-out ends of the coupler chip 10, the variable gain amplifier chip 11, and the driver chip 12 are all led from the upper surface S1 of the plastic packaging structure 30 to the lower surface S2 by using the via hole 31 in the plastic packaging structure 30, and details are not described again.

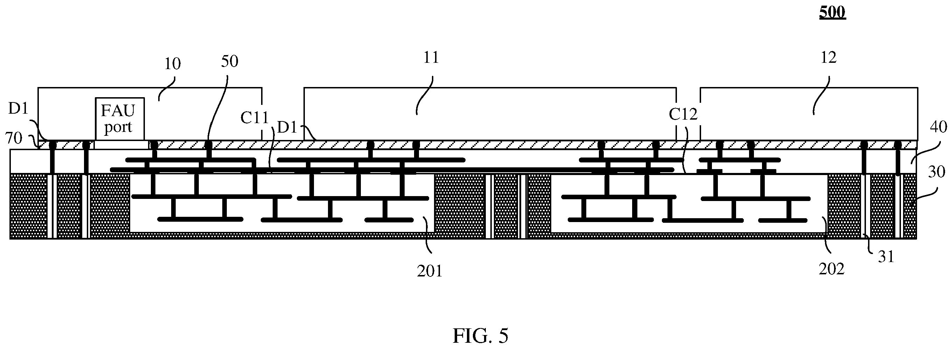

It can be learned from the packaging structure 400 of the optical communication module shown in FIG. 4 that every two adjacent chips can be connected by using the redistribution structure, and the packaging structure 400 cannot implement interconnection between two non-adjacent chips. Based on this, based on the packaging structure 400 of the optical communication module, embodiments of this application may further include a redistribution structure 40. Still refer to FIG. 5. FIG. 5 is a schematic diagram of a packaging structure 500 that includes the redistribution structure 40 and that is of the optical communication module. The redistribution structure 40 is disposed on a surface C11 of the redistribution structure 201, a surface C12 of the redistribution structure 202, and the surface S1 of the plastic packaging structure 30. The coupler chip 10, the variable gain amplifier chip 11, and the driver chip 12 are disposed on the redistribution structure 40 by using the micro bumps 50. The redistribution structure 40 includes at least one distribution layer, and each distribution layer includes a patterned conductive line and an insulation material for isolating the patterned conductive line. FIG. 5 schematically shows that the redistribution structure 40 includes two distribution layers. A conductive material configured to form the patterned conductive line may be metal, for example, one or a combination of metal such as copper (Cu), silver (Ag), aluminum (Al), and the like. The conductive material configured to form the patterned conductive line may alternatively be indium tin oxide (ITO), graphite, graphene, or the like. The insulation material may be an inorganic insulation material, an organic insulation material, or the like. The redistribution structure 40 may be further provided with a via (Via). The via may be filled with or electroplated with a conductive material, and the distribution layers communicate with each other by using the via. In the plurality of vias, a part of vias can be via holes that penetrate an upper surface and a lower surface of the redistribution structure 40, so that a part of lead-out ends of the chips can directly communicate with a conductive line on the redistribution structure 201 or the redistribution structure 202 by using the via holes on the redistribution structure 40, to implement interconnection between adjacent chips. In addition, a part of lead-out ends of the chips may alternatively be directly connected to the via holes 31 by using the via holes on the redistribution structure 40. Therefore, in the packaging structure 500 of the optical communication module shown in FIG. 5, the coupler chip 10 communicates with the variable gain amplifier chip 11 by using the via holes on the redistribution structure 40 and the redistribution structure 201, the variable gain amplifier chip 11 communicates with the driver chip 12 by using the via holes on the redistribution structure 40 and the redistribution structure 202, and the coupler chip 10 communicates with the driver chip 12 by using a conductive line on the redistribution structure 40. In addition, a part of lead-out ends of the coupler chip 10, the variable gain amplifier chip 11, and the driver chip 12 all communicate with the via holes 31 in the plastic packaging structure 30 by using the via holes on the redistribution structure 40, to implement communication between the conductive line on the PCB and the coupler chip 10, the variable gain amplifier chip 11, and the driver chip 12.

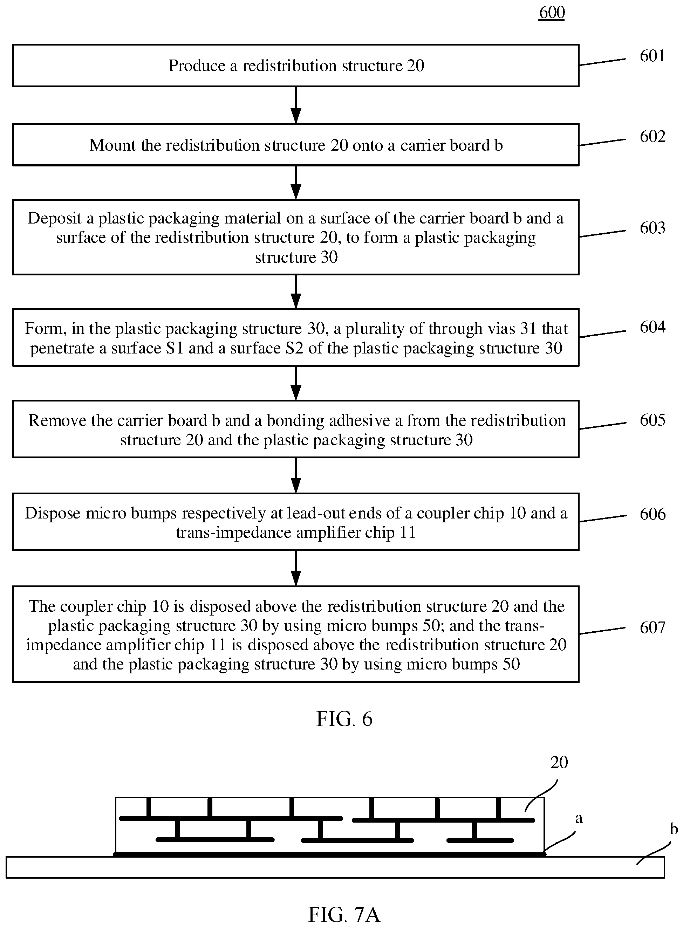

Based on the packaging structure of the optical communication module described in the foregoing embodiments, an embodiment of this application further provides a production method of a packaging structure of an optical communication module. The following describes in detail a process of producing the packaging structure of the optical communication module with reference to a process 600 shown in FIG. 6 by using an example in which the produced packaging structure of the optical communication module is shown in FIG. 1. The process 600 includes the following steps.

Step 601: Produce a redistribution structure 20. In this embodiment of this application, at least one distribution layer may be produced in a silicon crystal by using a standard CMOS process such as photoetching, development, or etching.

Step 602: Mount the redistribution structure 20 onto a carrier board b. A structure formed after this step is shown in FIG. 7A. A material of the carrier board b may include but is not limited to: a silicon material, a glass material, a mixture of the silicon material and the glass material, or the like, and the carrier board b may be in a wafer-level size. In specific implementation, a surface of the redistribution structure 20 may be coated with a bonding adhesive a, and the surface that is of the redistribution structure 20 and that is coated with the bonding adhesive a is mounted onto the carrier board b; or a surface of the carrier board b may be coated with a bonding adhesive a, and the redistribution structure 20 is pasted on the carrier board b.

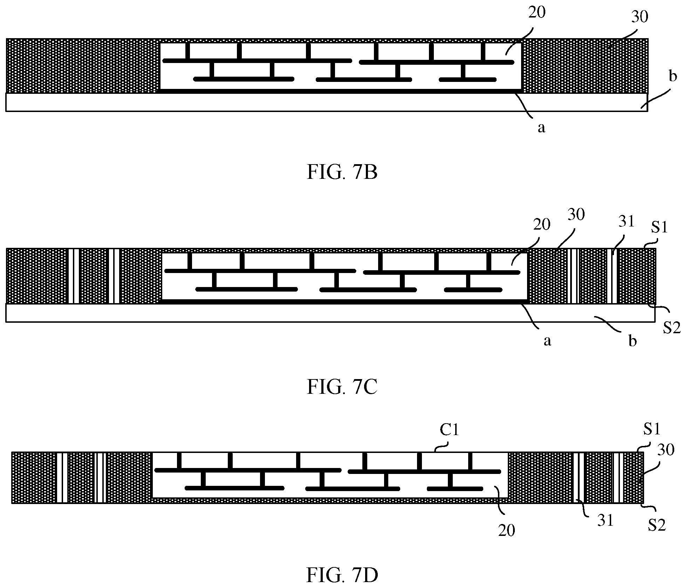

Step 603: Deposit a plastic packaging material on a surface of the carrier board b and a surface of the redistribution structure 20, to form a plastic packaging structure 30. A structure formed after this step is shown in FIG. 7B. It can be learned from FIG. 7B that both a lower surface and a side surface of the redistribution structure 20 are wrapped by the plastic packaging material 30.

Step 604: Form, in the plastic packaging structure 30, a plurality of via holes 31 that penetrate a surface S1 and a surface S2 of the plastic packaging structure 30. In practice, the plastic packaging structure may be etched by using an etching process (for example, laser etching or mechanical drilling) to form a hole that penetrates an upper surface and a lower surface of the plastic packaging structure 30; and then the hole may be filled with or electroplated with a conductive material (for example, copper) by using a filling process or an electroplating process, to form the plurality of via holes 31. A structure formed after this step is shown in FIG. 7C.

Step 605: Remove the carrier board b and the bonding adhesive a from the redistribution structure 20 and the plastic packaging structure 30. In this step, the carrier board b and the bonding adhesive a may be removed from the redistribution structure 20 and the plastic packaging structure 30 by using an ultraviolet separation process. A structure formed after this step is shown in FIG. 7D.

After step 605, both a surface C1 of the redistribution structure 20 and the surface S1 of the plastic packaging structure 30 are exposed.

Step 606: Dispose micro bumps respectively at lead-out ends of a coupler chip 10 and a trans-impedance amplifier chip 11.

Step 607: The coupler chip 10 is disposed on the redistribution structure 20 and the plastic packaging structure 30 by using the micro bump 50; and the trans-impedance amplifier chip 11 is also disposed on the redistribution structure 20 and the plastic packaging structure 30 by using the micro bump 50. One part of lead-out ends of the coupler chip 10 are connected to a conductive line on the redistribution structure 20 by using the micro bump, and the other part of lead-out ends are led from the surface S1 of the plastic packaging structure 30 to the surface S2 by using the micro bump. One part of lead-out ends of the trans-impedance amplifier chip 11 are connected to the conductive line on the redistribution structure 20 by using the micro bump 50, and the other part of lead-out ends are led from the surface S1 of the plastic packaging structure 30 to the surface S2 by using the micro bump. Therefore, the coupler chip 10 communicates with the trans-impedance amplifier chip 11 by using the redistribution structure 20; and lead-out ends such as a power supply terminal and a ground terminal of the coupler chip 10 and the trans-impedance amplifier chip 11 are led to a side that is of the plastic packaging structure 30 and that is configured to be welded to a PCB, to be connected to a line such as a power supply cable or a ground cable on the PCB.

In addition, after step 607, an insulation material 70 may be further filled between the coupler chip 10 and the redistribution structure 20 and the plastic packaging structure 30 and between the trans-impedance amplifier chip 11 and the redistribution structure 20 and the plastic packaging structure 30. The insulation material 70 may be, for example, an underfill. In addition, the insulation material 70 does not cover a region that is of the surface C1 of the redistribution structure 20 and the surface S1 of the plastic packaging structure 30 and that is covered by an orthographic projection of an FAU port.

After step 601 to step 607, the packaging structure 100 of the optical communication module shown in FIG. 1 can be formed.

Further, on the basis that the packaging structure 100 of the optical communication module shown in FIG. 1 is produced, board-level packaging may be further performed on the packaging structure 100 of the optical communication module, to form the optical communication device 200 shown in FIG. 2. When the board-level packaging needs to be performed, step 608 to step 610 may be further included. Step 608: Produce a conductive bump on a surface S2 of the plastic packaging structure 30, where the produced conductive bump is separately connected to the via holes 81. Step 609: Produce the PCB by using a standard process. Step 610: Weld the packaging structure 100 of the optical communication module to the PCB by using the conductive bump. FIG. 2 shows the optical communication device 200 produced in step 601 to step 610. When the packaging structure 300 of the optical communication module shown in FIG. 3 needs to be produced, based on the foregoing step 601 to step 607, the following steps may be further included. Step 611: Further deposit a plastic packaging material 60 on a surface of the coupler chip 10, a surface of the trans-impedance amplifier chip 11, the surface C1 of the redistribution structure 20, and the surface S1 of the plastic packaging structure 30. Step 612: Polish the plastic packaging material 60 on the chip 10 and the chip 11 (for example, the plastic packaging material 60 on the chip 10 and the chip 11 may be polished by using a chemical mechanical polishing process), to expose the coupler chip 10. Step 613: Etch a back of the chip 10 by using a photoetching process and a silicon plasma etching process, to release the port that is configured to couple the FAU and that is on the coupler chip 10. After step 601 to step 607, and step 611 to step 613, the packaging structure 300 of the optical communication module shown in FIG. 3 can be produced by using a wafer-level packaging process. When the packaging structure 400 of the optical communication module shown in FIG. 4 needs to be produced, the foregoing step 601 is replaced with producing a redistribution structure 201 and a redistribution structure 202. The foregoing step 602 is replaced with mounting the redistribution structure 201 and the redistribution structure 202 on a carrier board b. Between step 604 and step 605, step 613 that is disposing a redistribution structure 40 on surfaces of the redistribution structure 201, the redistribution structure 202, and the plastic packaging structure 30 is further included. The foregoing step 606 is replaced with disposing micro bumps respectively at lead-out ends of a coupler chip 10, a trans-impedance amplifier chip 11, and a driver chip 12. The foregoing step 607 is replaced with disposing the coupler chip 10, the trans-impedance amplifier chip 11, and the driver chip 12 on the redistribution structure 40 by using the micro bumps.

Finally, it should be noted that the foregoing embodiments are merely intended for describing the technical solutions of this application, but not for limiting this application. Although this application is described in detail with reference to the foregoing embodiments, a person of ordinary skill in the art should understand that he may still make modifications to the technical solutions described in the foregoing embodiments or make equivalent replacements to some or all technical features thereof, without departing from the scope of the technical solutions of embodiments of this application.

## Claims

1. A packaging structure of an optical communication module, comprising:
a first redistribution structure, wherein a distribution layer is disposed in the first redistribution structure;
a plastic packaging structure, wherein the plastic packaging structure wraps a surface other than an upper surface of the first redistribution structure, the plastic packaging structure on a periphery of the first redistribution structure is provided with at least one via hole, and each of the at least one via hole penetrates an upper surface and a lower surface of the plastic packaging structure; and
a first chip and a second chip, wherein the first chip and the second chip are disposed on the first redistribution structure and the plastic packaging structure, the first chip is connected to the second chip by using the distribution layer, and at least a part of lead-out ends of the first chip and at least a part of lead-out ends of the second chip are led from the upper surface of the plastic packaging structure to the lower surface by using the at least one via hole, to communicate with a conductive line on a printed circuit board.

2. The packaging structure according to claim 1, wherein the plastic packaging structure comprises a plurality of via holes;
the first chip is disposed on the upper surfaces of the first redistribution structure and the plastic packaging structure by using a plurality of first micro bumps, the first chip is connected to a conductive line in the distribution layer by using a second micro bump in the plurality of first micro bumps, and the first chip is connected to a first via hole in the plurality of via holes by using a third micro bump in the plurality of first micro bumps; and
the second chip is disposed on the upper surfaces of the first redistribution structure and the plastic packaging structure by using a plurality of fourth micro bumps, the second chip is connected to the conductive line in the distribution layer by using a fifth micro bump in the plurality of fourth micro bumps, and the second chip is connected to a second via hole in the plurality of via holes by using a sixth micro bump in the plurality of fourth micro bumps.

3. The packaging structure according to claim 1, wherein a second redistribution structure is further disposed on the upper surface of the first redistribution structure and the upper surface of the plastic packaging structure; and
the first chip is connected to the second chip by using the first redistribution structure and the second redistribution structure.

4. The packaging structure according to any one of claims 1 to 3, wherein the first chip comprises a port configured to couple a fiber array unit; and
the port is disposed on a first surface or a second surface of the first chip, the first surface is a surface that is of the first chip and that is close to the plastic packaging structure, and the second surface is a surface that is of the first chip and that is away from the plastic packaging structure.

5. The packaging structure according to claim 4, wherein when the port configured to couple the fiber array unit is disposed on the first surface of the first chip, an insulation material is filled between a region that is of the first chip and that is other than a region in which the port is disposed, and the first redistribution structure and the plastic packaging structure; and an insulation material is filled between the second chip and both of the first redistribution structure and the plastic packaging structure.

6. The packaging structure according to claim 4, wherein when the port configured to couple the fiber array unit is disposed on the second surface of the first chip, surfaces that are of the first chip and the second chip and that are other than a surface away from the first redistribution structure are wrapped by a plastic packaging material.

7. An optical communication device, wherein the optical communication device comprises a printed circuit board and the packaging structure of the optical communication module according to any one of claims 1 to 6;
at least one bump is disposed on a lower surface of the plastic packaging structure, and the at least a part of lead-out ends of the first chip and the at least a part of lead-out ends of the second chip are correspondingly connected to the at least one via hole by using the at least one bump;
the conductive line is disposed on the printed circuit board; and
the at least one bump is welded to the printed circuit board, and the first chip and the second chip are connected to the conductive line on the printed circuit board by using the at least one via hole and the at least one bump.

8. A production method of a packaging structure of an optical communication module, comprising:
producing a distribution layer in a silicon crystal, to form a first redistribution structure;
forming a plastic packaging structure on a periphery of the first redistribution structure, wherein the plastic packaging structure wraps a surface other than an upper surface of the first redistribution structure;
forming at least one via hole in the plastic packaging structure on the periphery of the first redistribution structure, wherein each of the at least one via hole penetrates an upper surface and a lower surface of the plastic packaging structure; and
disposing a first chip and a second chip on the first redistribution structure and the plastic packaging structure, wherein the first chip is connected to the second chip by using the distribution layer, and a part of lead-out ends of the first chip and a part of lead-out ends of the second chip are led from the upper surface of the plastic packaging structure to the lower surface by using the at least one via hole, to communicate with a conductive line on a printed circuit board.

9. The production method according to claim 8, wherein the disposing a first chip and a second chip on the first redistribution structure and the plastic packaging structure comprises:
disposing the first chip on the upper surfaces of the first redistribution structure and the plastic packaging structure by using a plurality of first micro bumps, wherein the first chip is connected to a conductive line in the distribution layer by using a second micro bump in the plurality of first micro bumps, and the first chip is connected to a first via hole in the plurality of via holes by using a third micro bump in the plurality of first micro bumps; and
disposing the second chip on the upper surfaces of the first redistribution structure and the plastic packaging structure by using a plurality of fourth micro bumps, wherein the second chip is connected to the conductive line in the distribution layer by using a fifth micro bump in the plurality of fourth micro bumps, and the second chip is connected to a second via hole in the plurality of via holes by using a sixth micro bump in the plurality of fourth micro bumps.

10. The production method according to claim 8, wherein the disposing a first chip and a second chip on the first redistribution structure and the plastic packaging structure comprises:
forming a second redistribution structure on the upper surfaces of the first redistribution structure and the plastic packaging structure; and
disposing the first chip and the second chip on the second redistribution structure, wherein
the first chip is connected to the second chip by using the first redistribution structure and the second redistribution structure.

11. The production method according to any one of claims 8 to 10, wherein the first chip comprises a port configured to couple a fiber array unit, and when the port is disposed on a first surface that is of the first chip and that is close to the plastic packaging structure, the production method further comprises:
filling an insulation material at bottoms of the first chip and the second chip, and on the first redistribution structure and the plastic packaging structure, wherein
the insulation material does not cover a region in which the port is located.

12. The production method according to any one of claims 8 to 10, wherein the first chip comprises a port configured to couple a fiber array unit, and when the port is disposed on a second surface that is of the first chip and that is away from the plastic packaging structure, the production method further comprises:
forming a plastic packaging material around the first chip and the second chip, wherein the plastic packaging material wraps surfaces that are of the first chip and the second chip and that are other than a surface away from the first redistribution structure; and
polishing and etching a back surface of the first chip to expose the port.
